# EUROPEAN PATENT APPLICATION

(11) **EP 3 992 651 A1**
(43) Date of publication of application: **04.05.2022**
(21) Application number: 20877380.4
(22) Date of filing: 25.05.2020
(51) Int. Cl.: G01R 31/52

(54) **GROUNDING DETECTION METHOD AND DEVICE USING SAME**

(30) Priority: 16.10.2019 CN 201910983849
(71) Applicant: Sungrow Power Supply Co., Ltd., Hefei, Anhui 230088 (CN)
(72) Inventor: CHEN, Peng, Hefei, Anhui 230088 (CN); WU, Yongfu, Hefei, Anhui 230088 (CN); XU, Qingqing, Hefei, Anhui 230088 (CN)
(74) Representative: Zacco Norway AS
(86) International application number: PCT/CN2020/092061
(87) International publication number: WO 2021/073097

(57) **Abstract**

Provided are a grounding detection method and a device using same. The grounding detection method is applied to a controller in a PWM-control-type grid-connected inverter in a low-voltage power grid system, and comprises: when a PWM-control-type grid-connected inverter satisfies a grounding detection condition, first controlling a grounding power supply in the PWM-control-type grid-connected inverter to apply a preset current or a preset voltage between a preset position and the ground (S200), wherein the preset position is a pole of a direct-current bus in the PWM-control-type grid-connected inverter or an output end of an alternating-current-side coupling circuit; and then determining whether the voltage of a pole of the direct-current bus or the output end of the alternating-current-side coupling circuit with respect to the ground changes (S300), so as to determine whether the PWM-control-type grid-connected inverter is sufficiently grounded, thus realizing automatic detection of a grounding condition of the grid-connected inverter, thereby solving the problem in the prior art of the dependence on manual work.

## Description

The present application claims priority to Chinese Patent Application No. 201910983849.8, titled "GROUNDING DETECTION METHOD AND DEVICE USING SAME", filed on October 16, 2019, with the China National Intellectual Property Administration, which is incorporated herein by reference in its entirety.

### FIELD

The present disclosure relates to the field of power electronics technology, and in particular to a grounding detection method and a device to which the method is applied.

### BACKGROUND

At present, according to requirements of safety regulations, when a grounding point of a grid-connected inverter is reliably connected to an external grounding point, it is required to ensure that a leakage current of the inverter does not exceed a safe current of the human body. If the leakage current is large, the grid-connected inverter is required to have at least two grounding points to ensure reliable grounding.

However, during grid-connecting construction, poor grounding of the grid-connected inverter such as missed grounding, broken grounding wire or suspended grounding may be caused by human negligence, and consequently a worker is at a risk of being electrocuted when being in contact with a shell of the grid-connected inverter. In addition, after a long-term operation of the grid-connected inverter, poor grounding may be caused by the increase of impedance of a bottom line. If the poor grounding is not found in time, the worker is also at the risk of being electrocuted when being in contact with the shell of the grid-connected inverter.

In order to prevent the worker from being electrocuted when in contact with the shell of the grid-connected inverter, in the conventional technology, the worker usually tests a grounding impedance of the grid-connected inverter in the field using a test device. However, this detection method is manually dependent.

### SUMMARY

In view of the above, a grounding detection method and a device to which the method is applied are provided according to the present disclosure to automatically detect grounding of a grid -connected inverter.

In order to realize the above objective, the following technical solutions are provided according to the present disclosure.

According to a first aspect of the present disclosure, a grounding detection method is provided. The method is applied to a controller in a PWM-controlled grid-connected inverter in a low-voltage grid system. The method includes: determining whether the PWM-controlled grid-connected inverter meets a grounding detection condition; controlling, in a case that the PWM-controlled grid-connected inverter meets the grounding detection condition, a grounding power supply in the PWM-controlled grid-connected inverter to apply a predetermined current or a predetermined voltage between a predetermined position in the PWM-controlled grid-connected inverter and ground, where the predetermined position is a pole of a direct current bus or an output terminal of an alternate current side coupling circuit; determining whether a voltage between the pole of the direct current bus and the ground or a voltage between the output terminal of the alternate current side coupling circuit and the ground changes; determining that the PWM-controlled grid-connected inverter is poorly grounded in a case that the voltage changes; and determining that the PWM-controlled grid-connected inverter is properly grounded in a case that the voltage does not change.

In an embodiment, the determining whether a voltage between the pole of the direct current bus and the ground or a voltage between the output terminal of the alternate current side coupling circuit and the ground changes includes: determining whether a voltage between a negative pole of the direct current bus and the ground gradually decreases and approaches a zero potential; or determining whether a voltage between a positive pole of the direct current bus and the ground gradually increases and approaches a voltage of the direct current bus; or determining whether the voltage between the output terminal of the alternate current side coupling circuit and the ground gradually increases and approaches a predetermined value.

In an embodiment, the grounding detection condition includes: a grounding detection instruction is received and/or predetermined detection time is reached.

In an embodiment, in a case that the predetermined position is a pole of the direct current bus, the grounding detection condition further includes: the PWM-controlled grid-connected inverter is in a grid-connected state.

In an embodiment, in a case that the predetermined position is the output terminal of the alternate current side coupling circuit, the grounding detection condition further includes: the PWM-controlled grid-connected inverter is in a standby state or in a grid-connected state.

According to a second aspect of the present disclosure, a controller is provided. The controller is configured to perform the grounding detection method according to the first aspect of the present disclosure.

In an embodiment, the controller is connected to an output terminal of a grounding detection switch button outside a device in which the controller is arranged, to receive a grounding detection instruction outputted by the grounding detection switch button.

In an embodiment, the controller is provided with a timing module configured to notify, when current time reaches the predetermined detection time, the controller to perform grounding detection.

According to a third aspect of the present disclosure, a PWM-controlled grid-connected inverter is provided. The inverter is applicable to a low-voltage grid system, and the inverter includes a main circuit, a grounding power supply, a detection module, an alternating current side coupling circuit and the controller according to the second aspect of the present disclosure. A direct current side of the main circuit is configured to receive or output direct current electric energy, and an alternating current side of the main circuit is configured to output or receive alternating current electric energy. An alternating current side of the alternating current side coupling circuit is connected to the alternating current side of the main circuit. A negative pole of the grounding power supply is connected to an internal grounding point of the PWM-controlled grid-connected inverter, and a positive pole of the grounding power supply is connected to a predetermined position in the PWM-controlled grid-connected inverter, where the predetermined position is a pole of a direct current bus in the main circuit or an output terminal of the alternating current side coupling circuit. An instruction output terminal of the controller is connected to a control terminal of the grounding power supply, a receiving terminal of the controller is connected to an output terminal of the detection module to receive a voltage between the pole of the direct current bus and the ground or a voltage between the output terminal of the alternating current side coupling circuit and the ground, where the voltage is detected by the detection module.

In an embodiment, the grounding power supply includes a controllable direct current voltage source and a current limiting resistor. A positive pole of the controllable direct current voltage source is connected to the positive pole of the grounding power supply, and a negative pole of the controllable direct current voltage source is connected to the negative pole of the grounding power supply. The current limiting resistor is arranged between the positive pole of the controllable direct current voltage source and the positive pole of the grounding power supply, or between the negative pole of the controllable direct current voltage source and the negative pole of the grounding power supply. A control terminal of the controllable direct current voltage source serves as the control terminal of the grounding power supply.

In an embodiment, the grounding power supply includes a controllable direct current source. A positive pole of the controllable direct current source serves as the positive pole of the grounding power supply. A negative pole of the controllable direct current source serves as the negative pole of the grounding power supply. A control terminal of the controllable direct current source serves as the control terminal of the grounding power supply.

In an embodiment, the alternate current side coupling circuit is a rectifier. The output terminal of the alternate current side coupling circuit is a direct current side positive pole or a direct current side negative pole of the rectifier. An alternate current side of the rectifier is connected to the alternate current side of the main circuit. Alternatively, the alternate current side coupling circuit is a Y-type circuit composed of impedances. The output terminal of the alternate current side coupling circuit is a virtual N point of the Y-type circuit, and other three terminals of the Y-type circuit are connected to the alternate current side of the main circuit.

In an embodiment, the main circuit includes an inverter circuit, or includes an inverter circuit and multiple boost circuits, where high voltage sides of the boost circuits are connected in parallel with each other to the direct current bus.

According to a fourth aspect of the present disclosure, a low-voltage grid system is provided. The system includes a transformer, at least one direct current power supply, and the PWM-controlled grid-connected inverter according to the third aspect of the present disclosure. A direct current side of the PWM-controlled grid-connected inverter is connected to the direct current power supply. An alternate current side of the PWM-controlled grid-connected inverter is connected to a grid through the transformer. A neutral point of the transformer is grounded.

It can be seen from the above technical solutions that a grounding detection method and a device to which the method is applied are provided according to the present disclosure. The grounding detection method according to the present disclosure is applied to a controller in a PWM-controlled grid-connected inverter in a low-voltage grid system. Compared with the conventional technology, the controller of the PWM-controlled grid-connected inverter first controls, in a case that the PWM-controlled grid-connected inverter meets the grounding detection condition, the grounding power supply in the PWM-controlled grid-connected inverter to apply the predetermined current or the predetermined voltage between the predetermined position in the PWM-controlled grid-connected inverter and the ground. The predetermined position is a pole of the direct current bus or the output terminal of the alternate current side coupling circuit. Then the controller determines whether the PWM-controlled grid-connected inverter is properly grounded by determining whether the voltage between the pole of the direct current bus and the ground or the voltage between the output terminal of the alternate current side coupling circuit and the ground changes, so that automatic detection of the grounding of the grid-connected inverter is realized, solving the problem of manual dependence in the conventional technology.

### BRIEF DESCRIPTION OF THE DRAWINGS

Figure 1 is a flowchart of a grounding detection method according to an embodiment of the present disclosure;
Figure 2 and Figure 3 are structural schematic diagrams each showing a PWM-controlled grid-connected inverter according to an embodiment of the present disclosure;
Figure 4 is a structural schematic diagram of a rectifier according to an embodiment of the present disclosure;
Figure 5 is a structural schematic diagram of a Y-type circuit according to an embodiment of the present disclosure;
Figure 6a is a structural schematic diagram of a TN-C system according to an embodiment of the present disclosure;
Figure 6b is a structural schematic diagram of a TN-C-S system according to an embodiment of the present disclosure;
Figure 6c is a structural schematic diagram of a TN-S system according to an embodiment of the present disclosure; and
Figure 6d is a structural schematic diagram of a TT system according to an embodiment of the present disclosure.

### DETAILED DESCRIPTION OF EMBODIMENTS

Technical solutions of embodiments of the present disclosure are described below clearly and completely in conjunction with the drawings of the embodiments of the present disclosure. Apparently, the embodiments described below are only some embodiments of the present disclosure, rather than all the embodiments. Any other embodiments obtained by those skilled in the art based on the embodiments in the present disclosure without any creative effort fall within the protection scope of the present disclosure.

In the present disclosure, terms of "include", "comprise" or any other variants are intended to be non-exclusive. Therefore, a process, a method, an article or a device including multiple elements includes not only the elements but also other elements that are not enumerated, or also include elements inherent in the process, the method, the article or the device. Unless expressively limited otherwise, the statement "comprising (including) one..." does not exclude a case that other similar elements may exist in the process, the method, the article or the apparatus.

In order to automatically detect grounding of a grid-connected inverter, a grounding detection method is provided according to an embodiment of the present disclosure. The method is applied to a controller of a PWM-controlled grid-connected inverter in a low-voltage grid system.

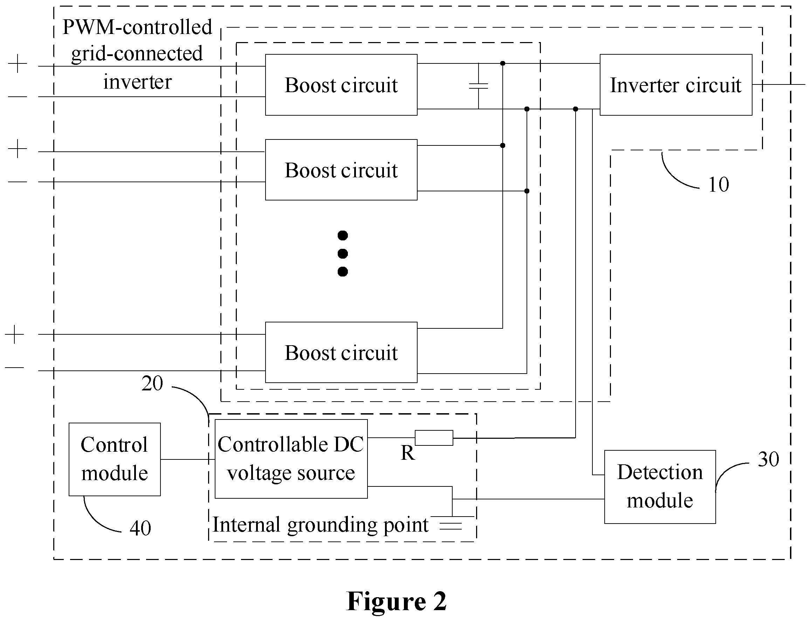

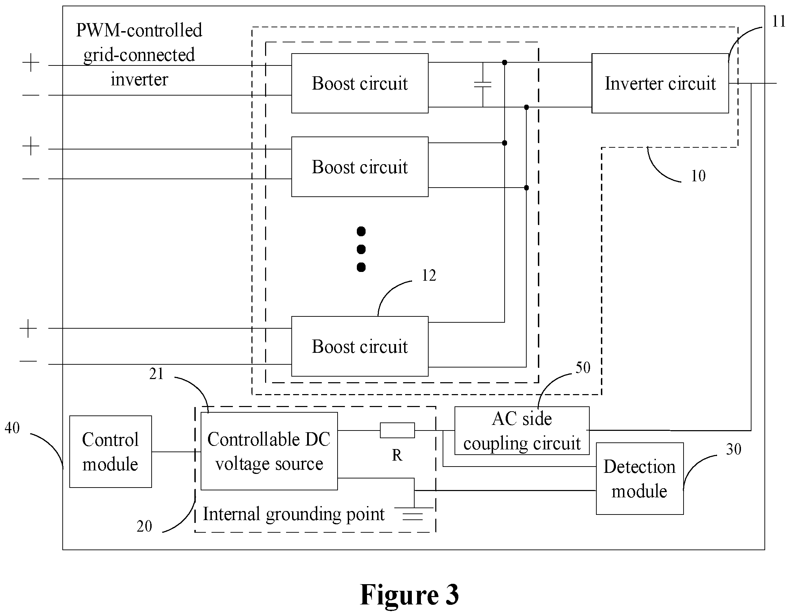

A structure of the PWM-controlled grid-connected inverter is as shown in Figures 2 and 3. The PWM-controlled grid-connected inverter includes a main circuit 10, a grounding power supply 20, a detection module 30, a controller 40, and an alternating current side coupling circuit 50 (not shown in Figure 2).

A direct current side of the main circuit 10 is configured to receive or output direct current electric energy, and an alternating current side of the main circuit 10 is configured to output or receive alternating current electric energy. An alternating current side of the alternating current side coupling circuit 50 is connected to the alternating current side of the main circuit 10.

A positive pole of the grounding power supply 20 is connected to a predetermined position in the PWM-controlled grid-connected inverter. The predetermined position is a pole (a negative pole is shown in Figure 2 as an example) of a direct current bus, or an output terminal (a left terminal of the alternating current side coupling circuit 50 shown in Figure 3) of the alternating current side coupling circuit. A negative pole of the grounding power supply 20 is connected to an internal grounding point of the PWM-controlled grid-connected inverter.

An instruction output terminal of the controller 40 is connected to a control terminal of the grounding power supply 20. A receiving terminal of the controller 40 is connected to an output terminal of the detection module 30 to receive a voltage between a pole of the direct current bus and the ground, or a voltage between the output terminal of the alternating current side coupling circuit 50 and the ground, where the voltage is detected by the detection module 30.

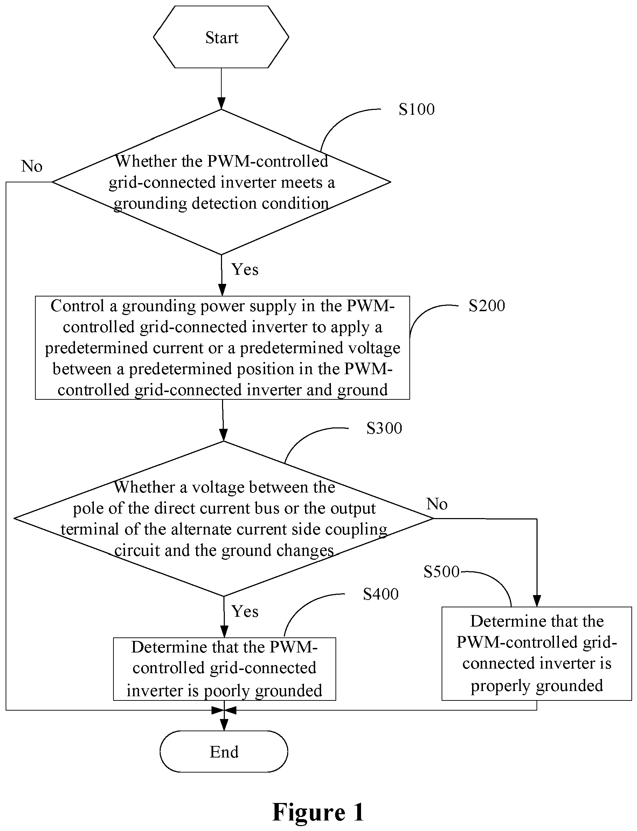

A flowchart of the grounding detection method is as shown in Figure 1, and the method includes the following steps S 100 to S500.

In step S100, it is determined whether the PWM-controlled grid-connected inverter meets a grounding detection condition.

The grounding detection condition of the PWM-controlled grid-connected inverter is that a grounding detection instruction is received and/or predetermined detection time is reached. In practical application, the grounding detection instruction is generated by a worker pressing a grounding detection button when grounding detection is required to be performed on the PWM-controlled grid-connected inverter. It should be noted that only one grounding detection instruction is generated after pressing the grounding detection button once, and that the predetermined detection time may be at least one time instant that is determined in advance, or at least one periodic time instant that is determined in advance. The predetermined detection time is not limited in the present disclosure and may be determined according to specific conditions, which shall all fall within the protection scope of the present disclosure.

In practical application, grounding detection is performed on the PWM-controlled grid-connected inverter only when the grounding detection instruction is received and/or the predetermined time is reached. In a case that the PWM-controlled grid-connected inverter meets the grounding detection condition, step S200 is performed. In a case that the PWM-controlled grid-connected inverter does not meet the grounding detection condition, grounding detection is not performed on the PWM-controlled grid-connected inverter.

In practical application, in a case that the predetermined position is a pole of the direct current bus, the grounding detection condition further includes: the PWM-controlled grid-connected inverter is in a grid-connected state.

The grid-connected state of the PWM-controlled grid-connected inverter refers to the state of the PWM-controlled grid-connected inverter when all switches in the main circuit 10 of the PWM-controlled grid-connected inverter are switched on.

It should be noted that in a case that the predetermined position is a pole of the direct current bus, the PWM-controlled grid-connected inverter meets the grounding detection condition if the PWM-controlled grid-connected inverter is in the grid-connected state and the controller 40 of the PWM-controlled grid-connected inverter receives the grounding detection instruction. Alternatively, the PWM-controlled grid-connected inverter meets the grounding detection condition if the PWM-controlled grid-connected inverter is in the grid-connected state and current time reaches the predetermined detection time.

In practical application, in a case that the predetermined position is the output terminal of the alternating current side coupling circuit 50, the grounding detection condition further includes that the PWM-controlled grid-connected inverter is in a standby state or in the grid-connected state.

The standby state of the PWM-controlled grid-connected inverter refers to the state of the PWM-controlled grid-connected inverter when all the switches in the main circuit 10 of the PWM-controlled grid-connected inverter are switched off. It can be seen that the standby state is a state before the grid-connected state.

It should be noted that in a case that the predetermined position is the output terminal of the alternate current side coupling circuit 50, the PWM-controlled grid-connected inverter meets the grounding detection condition if the PWM-controlled grid-connected inverter is in the standby state or the grid-connected state and the controller 40 of the PWM-controlled grid-connected inverter receives the grounding detection instruction. Alternatively, the PWM-controlled grid-connected inverter meets the grounding detection condition if the PWM-controlled grid-connected inverter is in the standby state or the grid-connected state and current time reaches the predetermined detection time.

In step S200, the grounding power supply in the PWM-controlled grid-connected inverter is controlled to apply a predetermined current or a predetermined voltage between the predetermined position in the PWM-controlled grid-connected inverter and the ground.

The predetermined current is a predetermined input current and the predetermined voltage is a predetermined input voltage. In practical application, the predetermined current and the predetermined voltage are determined properly according to actual situations.

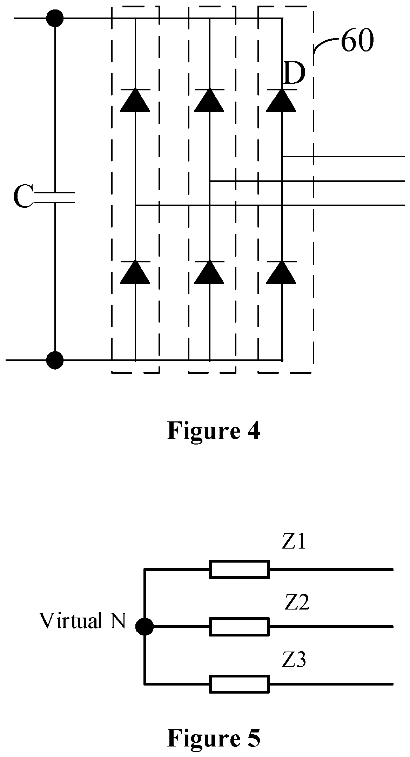

The predetermined position in Figure 2 is the negative pole of the direct current bus. A case in which the predetermined position is the positive pole of the direct current bus is not shown in the Figure. The predetermined position in Figure 3 is the output terminal of the alternate current side coupling circuit 50. In practical application, the alternate current side coupling circuit 50 may be a rectifier shown in Figure 4 or a Y-type circuit composed of impedances shown in Figure 5. In a case that the alternate current side coupling circuit 50 is the rectifier, the alternate current side of the rectifier is connected to the alternate current side of the main circuit 10. The output terminal of the alternate current side coupling circuit 50 is a direct current side positive pole or a direct current side negative pole of the rectifier. In a case that the alternate current side coupling circuit 50 is the Y-type circuit composed of impedances, other three terminals of the Y-type circuit are connected to the alternate current side of the main circuit 10 and the output terminal of the alternate current side coupling circuit 50 is a virtual N (neutral) point of the Y-type circuit.

In step S300, it is determined whether the voltage between a pole of the direct current bus and the ground or the voltage between the output terminal of the alternate current side coupling circuit and the ground changes.

In practical application, if the voltage between a pole of the direct current bus and the ground or the voltage between the output terminal of the alternate current side coupling circuit and the ground changes, it indicates that the applied predetermined current or predetermined voltage cannot be completely conducted to the ground, and step S400 is performed. If the voltage between the pole of the direct current bus and the ground or the voltage between the output terminal of the alternate current side coupling circuit and the ground does not change, it indicates that the applied predetermined current or predetermined voltage is completely conducted to the ground, and step S500 is performed.

No matter the predetermined position is a pole of the direct current bus or the output terminal of the alternate current side coupling circuit 50, it can be determined whether the grounding of the PWM-controlled grid-connected inverter is poor by determining whether the voltage between the pole of the direct current bus and the ground or the voltage between the output terminal of the alternate current side coupling circuit 50 and the ground changes. In addition, in practical application, it is determined whether the voltage between the negative pole of the direct current bus and the ground changes by: determining whether the voltage between the negative pole of the direct current bus and the ground gradually decreases and approaches zero potential. It is determined whether the voltage between the positive pole of the direct current bus and the ground changes by: determining whether the voltage between the positive pole of the direct current bus and the ground gradually increases and approaches a voltage of the direct current bus. In a case that the voltage between the negative pole of the direct current bus and the ground gradually decreases and approaches zero potential, or in a case that the voltage between the positive pole of the direct current bus and the ground gradually increases and approaches the voltage of the direct current bus, step S400 is performed. In a case that the voltage between the negative pole of the direct current bus and the ground remains unchanged, or in a case that the voltage between the positive pole of the direct current bus and the ground remains unchanged, step S500 is performed.

In a case that the alternating current side coupling circuit 50 is the Y-type circuit, it is determined whether the voltage between the output terminal of the alternating current side coupling circuit 50 and the ground changes by: determining whether a voltage between the virtual N point of the Y-type circuit and the ground gradually increases and approaches a predetermined value. In a case that the voltage between the virtual N point of the Y-type circuit and the ground gradually increases and approaches the predetermined value, step S400 is performed. In a case that the voltage between the virtual N point of the Y-type circuit and the ground remains unchanged, step S500 is performed. The predetermined value refers to a specific value of the predetermined current or the predetermined voltage applied by the grounding power supply 20 under the control of the controller 40.

It should be noted that in a case that the predetermined position is a pole of the direct current bus, grounding detection may be performed by detecting a change of the voltage between the pole of the direct current bus and the ground by the controller 40 after grid connection, or grounding detection may be performed by detecting a change of the voltage between the alternate current side coupling circuit 50 and the ground. In a case that the predetermined position is the output terminal of the alternate current side coupling circuit 50, the grounding power supply 20 may be controlled to apply a predetermined current or a predetermined voltage to the output terminal of the alternate current side coupling circuit 50 before grid connection. The direct current bus realizes soft start and establishes a normal direct current bus voltage under reverse conversion of an inverter circuit in the main circuit 10. Therefore, after the predetermined current or the predetermined voltage is applied to the output terminal of the alternate current side coupling circuit 50, a voltage change can be detected both at the output terminal of the alternate current side coupling circuit 50 and at a pole of the direct current bus, if the PWM-controlled grid-connected inverter has a ground fault.

In addition, in a case that the predetermined position is the output terminal of the alternate current side coupling circuit 50, whether the grounding of the PWM-controlled grid-connected inverter is poor is determined by determining whether the voltage between the output terminal of the alternate current side coupling circuit 50 and the ground changes, so that a relevant operation performed on the main circuit 10 of the inverter circuit can be avoided, simplifying the detection step.

In step S400, it is determined that the PWM-controlled grid-connected inverter is poorly grounded.

In step S500, it is determined that the PWM-controlled grid-connected inverter is properly grounded.

It should be noted that in the embodiment, step S100 may be performed according to its own period, and step S200, step S300, step S400 and step S500 are triggered and performed according to the above logic. That is, only after step S100 is performed, step S200, step S300, step S400 and step S500 are performed. In addition, from an overall perspective, in the whole detection process, it is determined every period whether to perform grounding detection on the PWM-controlled grid-connected inverter. In a case that the period is minimal, it can be continuously determined whether to perform grounding detection on the PWM-controlled grid-connected inverter, so that grounding detection can be performed on the PWM-controlled grid-connected inverter in time.

Alternatively, step S100, step S200, step S300, step S400 and step S500 may also be triggered and performed according to the above logic cycle. That is, after step S400 or step S500 in the whole detection process is performed, the process returns to step S100, so that step S100, step S200, step S300, step S400 and step S500 form a cycle. Based on the cycle, it can be continuously determined whether to perform grounding detection on the PWM-controlled grid-connected inverter, so that grounding detection can be performed on the PWM-controlled grid-connected inverter in time. However, it should be noted that the detection process starts immediately after the controller 40 starts.

It can be seen from the above technical solutions that the controller 40 of the PWM-controlled grid-connected inverter first controls, in a case that the PWM-controlled grid-connected inverter meets the grounding detection condition, the grounding power supply 20 in the PWM-controlled grid-connected inverter to apply the predetermined current or the predetermined voltage between the predetermined position in the PWM-controlled grid-connected inverter and the ground. The predetermined position is a pole of the direct current bus or the output terminal of the alternate current side coupling circuit 50. Then the controller determines whether the PWM-controlled grid-connected inverter is properly grounded by determining whether the voltage between the pole of the direct current bus and the ground or the voltage between the output terminal of the alternate current side coupling circuit 50 and the ground changes, so that automatic detection of the grounding of the PWM-controlled grid-connected inverter is realized, solving the problem of manual dependence in the conventional technology.

It is worth noting that with the grounding detection method according to the embodiment, whether the PWM-controlled grid-connected inverter is properly grounded is determined only by determining whether the voltage between a pole of the direct current bus and the ground or the voltage between the output terminal of the alternate current side coupling circuit 50 and the ground changes before and after the grounding power supply 20 applies the predetermined current or the predetermined voltage between the predetermined position in the PWM-controlled grid-connected inverter and the ground. Therefore, the grounding detection method according to the embodiment is simple, convenient and reliable.

A controller is provided according to another embodiment of the present disclosure. The controller is configured to perform the grounding detection method shown in Figure 1.

In practical application, the controller is connected to an output terminal of a grounding detection switch button outside a device in which the controller is arranged, to receive a grounding detection instruction outputted by the grounding detection switch button. It should be noted that the grounding detection switch button generates the grounding detection instruction by pressing the grounding detection switch button by the worker when it is required to perform grounding detection on the PWM-controlled grid-connected inverter.

In addition, in practical application, the controller is provided with a timing module. The timing module is configured to notify, when the current time reaches the predetermined detection time, the controller to perform grounding detection.

A PWM-controlled grid-connected inverter is provided according to another embodiment of the present disclosure. The PWM-controlled grid-connected inverter is suitable for a low-voltage grid system. A structure of the inverter is as shown in Figures 2 and 3. The PWM-controlled grid-connected inverter includes a main circuit 10, a grounding power supply 20, a detection module 30, an alternating current side coupling circuit 50 (not shown in Figure 2) and the controller 40 according to the previous embodiment.

A direct current side of the main circuit 10 is configured to receive or output direct current electric energy, and an alternating current side of the main circuit 10 is configured to output or receive alternating current electric energy. An alternating current side of the alternating current side coupling circuit 50 is connected to the alternating current side of the main circuit 10.

A negative pole of the grounding power supply 20 is connected to an internal grounding point of the PWM-controlled grid-connected inverter. A positive pole of the grounding power supply 20 is connected to a predetermined position in the PWM-controlled grid-connected inverter.

An instruction output terminal of the controller 40 is connected to a control terminal of the grounding power supply 20. A receiving terminal of the controller 40 is connected to an output terminal of the detection module 30 to receive a voltage between a pole of the direct current bus, that is, the positive pole or the negative pole (as shown in Figure 2) of the direct current bus, and the ground, or a voltage between the output terminal (as shown in Figure 3) of the alternating current side coupling circuit 50 and the ground, where the voltage is detected by the detection module 30.

It should be noted that if the grounding detection function is not realized by using the alternate current side coupling circuit 50, the predetermined position is a pole of the direct current bus. Figure 2 shows a case in which the predetermined position is the negative pole of the direct current bus as an example. In this case, the voltage received by the receiving terminal of the controller 40 through the detection module 30 may be the voltage between the negative pole of the direct current bus and the ground or the voltage between the positive pole of the direct current bus and the ground, which is not limited in the present disclosure. The voltage may be determined according to actual conditions, which shall all fall within the protection scope of the present disclosure.

If the grounding detection function is realized by using the alternate current side coupling circuit 50, the predetermined position is the output terminal of the alternate current side coupling circuit 50. In this case, the voltage received by the receiving terminal of the controller 40 through the detection module 30 may be the voltage between a pole of the direct current bus and the ground (not shown in the Figure), or the voltage between the output terminal of the alternate current side coupling circuit 50 and the ground (as shown in Figure 3), which is not limited in the present disclosure. The voltage may be determined according to actual conditions, which shall all fall within the protection scope of the present disclosure. In addition, if the grounding detection function is realized by using the alternate current side coupling circuit 50, the predetermined position may also be a pole of the direct current bus. In this case, the voltage received by the receiving terminal of the controller 40 through the detection module 30 is the voltage between the output terminal of the alternate current side coupling circuit 50 and the ground.

In practical application, the alternate current side coupling circuit 50 may be a rectifier, and a structure of the rectifier is as shown in Figure 4. The rectifier includes a capacitor C and three rectifier branches 60 each of which is composed of two diodes D in series.

Positive poles of the three rectifier branches 60 are connected to a terminal of the capacitor C, and a connection point serves as a direct current side positive pole of the rectifier. The positive poles of the three rectifier branches 60 are connected to the other terminal of the capacitor C, and a connection point serves as a direct current side negative pole of the rectifier. The output terminal of the alternate current side coupling circuit 50 refers to a positive pole or a negative pole of the direct current side of the rectifier. Middle connection points of the three rectifier branches 60 serve as the alternate current side of the rectifier and are respectively connected to connection points in phases of the alternate current side of the main circuit 10.

In practical application, the alternate current side coupling circuit 50 may also be a Y-type circuit composed of impedances. A structure of the Y-type circuit is as shown in Figure 5. The Y-type circuit includes a first impedance Z1, a second impedance Z2 and a third impedance Z3.

A terminal of the first impedance Z1, a terminal of the second impedance Z2 and a terminal of the third impedance Z3 are connected at a connection point, and the connection point serves as a virtual N point of the Y-type circuit. The output terminal of the alternate current side coupling circuit 50 refers to the virtual N point of the Y-type circuit. The other terminal of the first impedance Z1, the other terminal of the second impedance Z2 and the other terminal of the third impedance Z3 are all connected to the alternate current side of the main circuit 10.

It should be noted that the first impedance Z1, the second impedance Z2 and the third impedance Z3 may be resistors, capacitors, inductors, or a combination of at least any two of a resistor, a capacitor and an inductor, which is not limited in the present disclosure. The first impedance Z1, the second impedance Z2 and the third impedance Z3 may be determined according to actual conditions, which shall all fall within the protection scope of the present disclosure.

The grounding detection method performed by the controller 40 may be referred to the above embodiments and are not repeated herein. It is worth noting that for the PWM-controlled grid-connected inverter shown in Figure 2, in a case that the predetermined position is a pole of the direct current bus and the detection module 30 detects the voltage between the output terminal of the alternate current side coupling circuit 50 and the ground, the controller 40 can perfrom grounding detection only after grid connection. For the PWM-controlled grid-connected inverter shown in Figure 3, in a case that the predetermined position is the output terminal of the alternate current side coupling circuit 50 and the detection module 30 detects the voltage between the negative pole of the direct current bus and the ground, the controller 40 can perform grounding detection not only after grid connection but also before grid connection. In particular, if the structure of the alternate current side coupling circuit 50 is as shown in Figure 5, in a case that the predetermined position to which the grounding power supply 20 in the PWM-controlled grid-connected inverter applies the predetermined voltage or the predetermined current is the output terminal of the alternate current coupling circuit 50 and the detection module 30 detects the voltage between the output terminal of the alternate current side coupling circuit 50 and the ground, not only can the grounding detection be performed before grid connection, but also a relevant operation on the main circuit 10 can be avoided.

An implementation of the grounding power supply 20 is provided according to another embodiment of the present disclosure. A structure of the grounding power supply 20 is as shown in Figure 2 or Figure 3. The grounding power supply 20 includes a controllable direct current voltage source 21 and a current limiting resistor R.

A positive pole of the controllable direct current voltage source 21 is connected to the positive pole of the grounding power supply 20. A negative pole of the controllable direct current voltage source 21 is connected to the negative pole of the grounding power supply 20. A control terminal of the controllable direct current voltage source 21 serves as the control terminal of the grounding power supply 20. The current limiting resistor R is arranged between the positive pole of the controllable direct current voltage source 21 and the positive pole of the grounding power supply 20, or between the negative pole of the controllable direct current voltage source 21 and the negative pole of the grounding power supply 20.

It should be noted that the current limiting resistor R is capable of effectively limiting output capacity of the controllable direct current voltage source 21 and protecting a worker from being electrocuted.

Only a preferred implementation of the grounding power supply 20 is shown above. In practical application, the grounding power supply 20 may further include a controllable direct current source. A positive pole of the controllable direct current source serves as the positive pole of the grounding power supply 20. A negative pole of the controllable direct current source serves as the negative pole of the grounding power supply 20. A control terminal of the controllable direct current source serves as the control terminal of the grounding power supply 20. It should be noted that the implementation of the grounding power supply 20 may be determined according to actual conditions, and the two implementations are both within the protection scope of the present disclosure.

Two implementations of the main circuit 10 are further provided according to the embodiment. In a first implementation, the main circuit 10 includes an inverter circuit 11. In a second implementation, the main circuit 10 includes an inverter circuit 11 and multiple boost circuits 12, where high voltage sides of the boost circuits are connected in parallel with each other to the direct current bus (as shown in Figures 2 and 3). It should be noted that the implementation may be determined according to actual conditions, and the two implementations are both within the protection scope of the present disclosure.

It should be noted that the controller 40 according to the embodiment performs grounding detection on the PWM-controlled grid-connected inverter by using existing circuits in the PWM-controlled grid-connected inverter in the low-voltage grid system without adding a new circuit or using an external tool, thereby reducing cost and facilitating market promotion and competition.

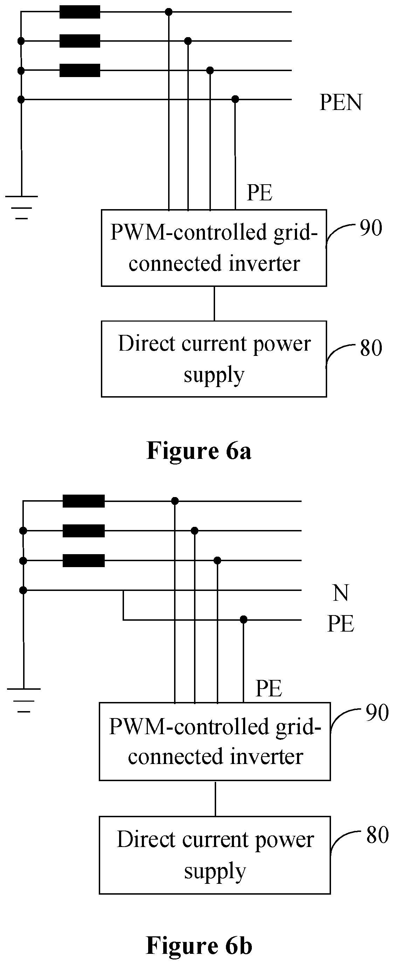

A low-voltage grid system is provided according to another embodiment of the present disclosure. A structure of the low-voltage grid system is as shown in Figures 6a to 6d. The low-voltage grid system includes a transformer (part of the transformer is indicated by black blocks in Figure 6a to Figure 6d), at least one direct current power supply 80, and the PWM-controlled grid-connected inverter 90 as shown in Figure 2 or Figure 3.

A direct current side of the PWM-controlled grid-connected inverter 90 is connected to the direct current power supply 80. An alternate current side of the PWM-controlled grid-connected inverter 90 is connected to the grid through the transformer. A neutral point of the transformer is grounded.

In an embodiment, the direct current power supply 80 may be a photovoltaic string, an energy storage system, or combination of a photovoltaic string and an energy storage system, which is not limited in the present disclosure. The direct current power supply 80 may be determined according to actual conditions, which shall all fall within the protection scope of the present disclosure.

In practical application, in a case that a PE line of the PWM-controlled grid-connected inverter 90 is connected to a PEN line of the transformer and the PEN line of the transformer is connected to the neutral point of the transformer, the PWM-controlled grid-connected inverter 90 and the transformer that are connected in the above manner form a TN-C system (as shown in Figure 6a).

In practical application, in a case that the PE line of the PWM-controlled grid-connected inverter 90 is connected to a PE line of the transformer, the PE line of the transformer is connected to an N line of the transformer, and a connection point of the PE line of the transformer and the N line of the transformer is connected to a neutral point of the transformer, the PWM-controlled grid-connected inverter 90 and the transformer that are connected in the above manner form a TN-C-S system (as shown in Figure 6b).

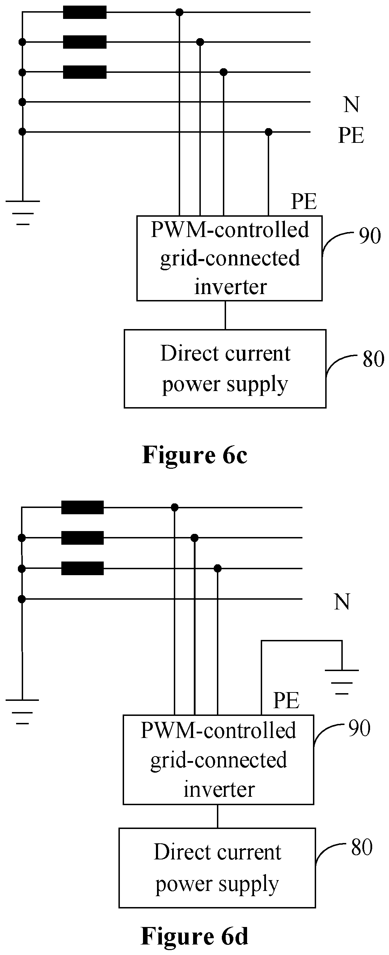

In practical application, in a case that the PE line of the PWM-controlled grid-connected inverter 90 is connected to the PE line of the transformer, and the N line and the PE line of the transformer are both connected to the neutral point of the transformer, the PWM-controlled grid-connected inverter 90 and the transformer that are connected in the above manner form a TN-S system (as shown in Figure 6c).

In practical application, in a case that the PE line of the PWM-controlled grid-connected inverter 90 is grounded and the N line of the transformer is connected to the neutral point of the transformer, the PWM-controlled grid-connected inverter 90 and the transformer that are connected in the above manner form a TT system (as shown in Figure 6d).

The above four manners in which the PWM-controlled grid-connected inverter 90 is connected to the transformer may be determined according to specific conditions, and are not limited, which shall all fall within the protection scope of the present disclosure.

It should be noted that the embodiments in this specification are described in a progressive way, each of which emphasizes the differences from others, and for the same or similar parts among the embodiments, one may refer to description of other embodiments. Since the system disclosed in the embodiments is basically similar to the method therein, the description thereof is relatively simple, and for relevant matters, one may refer to the description of the method embodiments. The system and embodiments of the system described in the above are merely illustrative. Units described as separate components may be or may not be physically separated. Components shown as units may be or may not be physical units, that is, may be located in one location or may be distributed in multiple network units. Parts or all of the modules may be selected based on actual conditions, to implement the technical solutions of the present disclosure. Those skilled in the art can understand and carry out the present disclosure without any creative effort.

It should be further understood by those skilled in the art that units described in combination with the disclosed embodiments may be implemented by electronic hardware, computer software or a combination thereof. In order to clearly describe interchangeability of the hardware and the software, the units are generally described above based on functions. Whether the functions are realized by the hardware or the software is determined by specific applications of the technical solutions and design constraints. For each of the specific applications, those skilled in the art may adopt a specific implementation to realize the functions described above, and the implementation should fall within the protection scope of the present disclosure.

With the description of the embodiments disclosed above, those skilled in the art may implement or use technical solutions of the present disclosure. Numerous modifications to the embodiments are apparent to those skilled in the art, and the general principles defined herein may be implemented in other embodiments without departing from the spirit or scope of the present disclosure. Therefore, the present disclosure may not be limited to the embodiments described herein, but should comply with the widest scope consistent with the principles and novel features disclosed herein.

## Claims

1. A grounding detection method, applied to a controller in a PWM-controlled grid-connected inverter in a low-voltage grid system, the method comprising:
determining whether the PWM-controlled grid-connected inverter meets a grounding detection condition;
controlling, in a case that the PWM-controlled grid-connected inverter meets the grounding detection condition, a grounding power supply in the PWM-controlled grid-connected inverter to apply a predetermined current or a predetermined voltage between a predetermined position in the PWM-controlled grid-connected inverter and ground, wherein the predetermined position is a pole of a direct current bus or an output terminal of an alternate current side coupling circuit;
determining whether a voltage between the pole of the direct current bus and the ground or a voltage between the output terminal of the alternate current side coupling circuit and the ground changes;
determining that the PWM-controlled grid-connected inverter is poorly grounded in a case that the voltage changes; and
determining that the PWM-controlled grid-connected inverter is properly grounded in a case that the voltage does not change.

2. The grounding detection method according to claim 1, wherein the determining whether a voltage between the pole of the direct current bus and the ground or a voltage between the output terminal of the alternate current side coupling circuit and the ground changes comprises:
determining whether a voltage between a negative pole of the direct current bus and the ground gradually decreases and approaches a zero potential; or
determining whether a voltage between a positive pole of the direct current bus and the ground gradually increases and approaches a voltage of the direct current bus; or
determining whether the voltage between the output terminal of the alternate current side coupling circuit and the ground gradually increases and approaches a predetermined value.

3. The grounding detection method according to claim 1, wherein the grounding detection condition comprises:
a grounding detection instruction is received and/or predetermined detection time is reached.

4. The grounding detection method according to claim 3, wherein in a case that the predetermined position is a pole of the direct current bus, the grounding detection condition further comprises:
the PWM-controlled grid-connected inverter is in a grid-connected state.

5. The grounding detection method according to claim 3, wherein in a case that the predetermined position is the output terminal of the alternate current side coupling circuit, the grounding detection condition further comprises:
the PWM-controlled grid-connected inverter is in a standby state or in a grid-connected state.

6. A controller, wherein the controller is configured to perform the grounding detection method according to any one of claims 1 to 5.

7. The controller according to claim 6, wherein the controller is connected to an output terminal of a grounding detection switch button outside a device in which the controller is arranged, to receive a grounding detection instruction outputted by the grounding detection switch button.

8. The controller according to claim 6, wherein the controller is provided with a timing module configured to notify, when current time reaches the predetermined detection time, the controller to perform grounding detection.

9. A PWM-controlled grid-connected inverter, applicable to a low-voltage grid system, the inverter comprising a main circuit, a grounding power supply, a detection module, an alternating current side coupling circuit and the controller according to any one of claims 6 to 8, wherein:
a direct current side of the main circuit is configured to receive or output direct current electric energy, and an alternating current side of the main circuit is configured to output or receive alternating current electric energy;
an alternating current side of the alternating current side coupling circuit is connected to the alternating current side of the main circuit;
a negative pole of the grounding power supply is connected to an internal grounding point of the PWM-controlled grid-connected inverter, and a positive pole of the grounding power supply is connected to a predetermined position in the PWM-controlled grid-connected inverter, wherein the predetermined position is a pole of a direct current bus in the main circuit or an output terminal of the alternating current side coupling circuit; and
an instruction output terminal of the controller is connected to a control terminal of the grounding power supply, a receiving terminal of the controller is connected to an output terminal of the detection module to receive a voltage between the pole of the direct current bus and the ground or a voltage between the output terminal of the alternating current side coupling circuit and the ground, wherein the voltage is detected by the detection module.

10. The PWM-controlled grid-connected inverter according to claim 9, wherein the grounding power supply comprises a controllable direct current voltage source and a current limiting resistor, wherein:
a positive pole of the controllable direct current voltage source is connected to the positive pole of the grounding power supply, and a negative pole of the controllable direct current voltage source is connected to the negative pole of the grounding power supply;
the current limiting resistor is arranged between the positive pole of the controllable direct current voltage source and the positive pole of the grounding power supply, or between the negative pole of the controllable direct current voltage source and the negative pole of the grounding power supply; and
a control terminal of the controllable direct current voltage source serves as the control terminal of the grounding power supply.

11. The PWM-controlled grid-connected inverter according to claim 9, wherein the grounding power supply comprises a controllable direct current source, wherein:
a positive pole of the controllable direct current source serves as the positive pole of the grounding power supply;
a negative pole of the controllable direct current source serves as the negative pole of the grounding power supply; and
a control terminal of the controllable direct current source serves as the control terminal of the grounding power supply.

12. The PWM-controlled grid-connected inverter according to claim 9, wherein
the alternate current side coupling circuit is a rectifier, wherein:
the output terminal of the alternate current side coupling circuit is a direct current side positive pole or a direct current side negative pole of the rectifier; and
an alternate current side of the rectifier is connected to the alternate current side of the main circuit; or
the alternate current side coupling circuit is a Y-type circuit composed of impedances, wherein:
the output terminal of the alternate current side coupling circuit is a virtual N point of the Y-type circuit, and
other three terminals of the Y-type circuit are connected to the alternate current side of the main circuit.

13. The PWM-controlled grid-connected inverter according to claim 9, wherein the main circuit comprises:
an inverter circuit; or
an inverter circuit and a plurality of boost circuits, wherein high voltage sides of the boost circuits are connected in parallel with each other to the direct current bus.

14. A low-voltage grid system, wherein the system comprises a transformer, at least one direct current power supply, and the PWM-controlled grid-connected inverter according to any one of claims 9 to 13, wherein:
a direct current side of the PWM-controlled grid-connected inverter is connected to the direct current power supply;
an alternate current side of the PWM-controlled grid-connected inverter is connected to a grid through the transformer; and
a neutral point of the transformer is grounded.
